(19) Europäisches Patentamt

European Patent Office

Office européen des brevets

(11) **EP 3 085 736 B1**

(12) **EUROPEAN PATENT SPECIFICATION**

(45) Date of publication and mention
of the grant of the patent:
**13.06.2018 Bulletin 2018/24**

(21) Application number: **14871662.4**

(22) Date of filing: **17.12.2014**

(51) Int Cl.:
*C08L 63/00* (2006.01)   *C01G 23/00* (2006.01)
*C08K 3/28* (2006.01)   *C08K 9/06* (2006.01)
*C08L 101/00* (2006.01)   *H01L 23/29* (2006.01)
*H01L 23/31* (2006.01)

(86) International application number:
**PCT/JP2014/083324**

(87) International publication number:
**WO 2015/093498 (25.06.2015 Gazette 2015/25)**

(54) **BLACK TITANIUM OXYNITRIDE POWDER, AND SEMICONDUCTOR SEALING RESIN COMPOUND USING SAME**

SCHWARZES TITANOXYNITRIDPULVER UND HALBLEITERDICHTUNGSHARZVERBINDUNG DAMIT

POUDRE NOIRE D'OXYNITRURE DE TITANE ET COMPOSITION DE RÉSINE D'ENCAPSULATION DE SEMI-CONDUCTEUR L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2013 JP 2013261156**

(43) Date of publication of application:
**26.10.2016 Bulletin 2016/43**

(73) Proprietor: **Mitsubishi Materials Electronic Chemicals Co., Ltd.**
**Akita-shi**
**Akita 010-8585 (JP)**

(72) Inventors:
• **KAGEYAMA, Kensuke**
**Akita-shi**
**Akita 010-8585 (JP)**

• **ISHIKURO, Shigeki**
**Akita-shi**
**Akita 010-8585 (JP)**

(74) Representative: **Gille Hrabal**
**Brucknerstrasse 20**
**40593 Düsseldorf (DE)**

(56) References cited:
| JP-A- H01 141 963 | JP-A- H04 103 618 |
| JP-A- S62 136 861 | JP-A- 2001 083 315 |
| JP-A- 2002 267 832 | JP-A- 2002 285 007 |
| JP-A- 2004 204 175 | JP-A- 2006 182 627 |
| US-A1- 2008 017 835 | US-A1- 2008 318 018 |

EP 3 085 736 B1

**EP 3 085 736 B1**

**Description**

TECHNICAL FIELD

The present invention relates to black titanium oxynitride powder coated by a silica film, and a resin compound for sealing a semiconductor using the black titanium oxynitride powder as a filler.

BACKGROUND ART

It has heretofore been disclosed a carbon black colorant for sealing a semiconductor having a residue on a sieve with a pore diameter of 25 $\mu$m of 0% by weight and a residue on a filter paper of a quantitative filter paper No. 5A of 0.5 ppm or less, which is obtained by subjecting carbon black to wet oxidation treatment, filtering it through a filter having a pore size of 5 $\mu$m or less, then, spray drying a carbon black slurry in which a carbon black content has been adjusted to 3 to 50% by mass by concentration (for example, see Patent Document 1.). Since large aggregates have been removed from the carbon black colorant constituted as mentioned above, the resin composition for sealing a semiconductor using the colorant has been suppressed to cause electrical failure by the aggregates, which has been caused by the aggregates of carbon black being sandwiched between wirings and the wirings are shortcircuited by the aggregates in a highly integrated semiconductor device. In addition, it is excellent in fluidity, moldability and laser marking property of the resin composition, and is suitable for sealing a semiconductor device such as IC, LSI, etc.

Patent documents 2 to 5 disclose some examples of black titanium oxynitride in prior art.

PRIOR ART REFERENCES

PATENT DOCUMENT

Patent document 1: JP2005-206621A (claim 1, Paragraph [0019])
Patent document 2: US2008/017835 A1
Patent document 3: US2008/318018 A1
Patent document 4: JP2006-182627 A
Patent document 5: JP2002-267832 A

SUMMARY OF THE INVENTION

PROBLEMS TO BE SOLVED BY THE INVENTION

The above-mentioned conventional carbon black for sealing a semiconductor shown in Patent Document 1, however, inherently has conductivity so that if a wiring pitch of a semiconductor device becomes further narrow as 30 $\mu$m or less, in the sealing material using the above-mentioned carbon black as a filler, there is a fear that aggregates of carbon black are sandwiched between the wirings whereby the wirings are shortcircuited. To solve this point, electrical insulation of the filler itself is required, and as a filler satisfying the requirement, i.e, a filler excellent in electrical insulation, there is a black titanium oxynitride powder (titanium black powder). However, with respect to the black titanium oxynitride powder, there is a concern of generation of an $\alpha$-ray caused by impurities (in particular, lead) contained in ilmenite ores (which is a raw material of titanium oxide becoming a raw material of the black titanium oxynitride). When a titanium oxide powder is produced by using the ilmenite ores and further a black titanium oxynitride powder is produced therefrom, and when a semiconductor device is sealed by a sealing material using the black titanium oxynitride powder as a filler, if an $\alpha$-ray is generated from the black titanium oxynitride powder, there is a fear of generating the so-called software error in which a malfunction of the semiconductor device occurs by the $\alpha$-ray.

An object of the present invention is to provide a black titanium oxynitride powder and a resin compound for sealing a semiconductor using the same, in which if it is used as a filler of a resin compound for sealing a semiconductor device, etc., no short-circuit of the wirings is generated even when the wiring pitch of the semiconductor device, etc., is narrow, and generation of the software error which is a malfunction of the semiconductor device, etc., by the $\alpha$-ray can be suppressed.

MEANS FOR SOLVING THE PROBLEMS

The first aspect of the present invention is directed to a black titanium oxynitride powder as described in our claim 1.

The second aspect of the present invention is a resin compound for sealing a semiconductor in which the black titanium oxynitride powder of the first aspect is dispersed in a mixture comprising an epoxy resin, a curing agent, a curing accelerator and an inorganic filler.

The third aspect of the present invention is an invention based on the second aspect, wherein a contained ratio of the black titanium oxynitride powder is 0.05 to 10% by mass based on 100% by mass of the total amount of the mixture of the epoxy resin, the curing agent, the curing accelerator and the inorganic filler, and the black titanium oxynitride powder.

The fourth aspect of the present invention is an invention based on the third aspect, which further comprises that the amount of an $\alpha$-ray emission is 0.1 cph/cm$^2$ or less.

EFFECTS OF THE INVENTION

In the black titanium oxynitride powder of the first aspect of the present invention, a volume resistivity in a state of a pressurized powder body of the black titanium oxynitride powder in which the surface of a powder matrix of the black titanium oxynitride has been coated by a silica film with a thickness of 2.5 to 12 nm and compacted with a pressure of 5 MPa is large as $1 \times 10^5$ $\Omega \cdot$cm or more, so that the black titanium oxynitride powder has high electrical insulation and a high shielding property to the $\alpha$-ray. As a result, when the black titanium oxynitride powder is used as a filler of the resin compound for sealing a semiconductor device, etc., even when wiring pitch of the semiconductor device, etc., becomes narrow, the black titanium oxynitride powder which is the filler does not short-circuit the wiring, and occurrence of a software error which is a malfunction by $\alpha$-ray of a semiconductor device, etc., can be suppressed.

Also, since the lightness index L* value of the black titanium oxynitride powder in the CIE 1976 L*a*b* color space (measurement light source C: color temperature 6774K) is made 14 or less, insufficiency of the blackness of the black titanium oxynitride powder can be prevented. As a result, when the above-mentioned black titanium oxynitride powder is used as a filler of the resin compound for sealing a semiconductor, a concealing property by the sealing material of the semiconductor device can be improved.

In the resin compound for sealing a semiconductor which is the second aspect of the present invention, the black titanium oxynitride powder contained in the resin compound for sealing a semiconductor has high electrical insulation and a high shielding property to the $\alpha$-ray, and when the resin compound is used as a sealing material for a semiconductor device, etc., even when a wiring pitch of the semiconductor device, etc., becomes narrow, the black titanium oxynitride powder in the sealing material does not short-circuit the wiring, and occurrence of software error which is a malfunction by an $\alpha$-ray of a semiconductor device, etc., can be suppressed.

In the resin compound for sealing a semiconductor which is the fourth aspect of the present invention, since the amount of the $\alpha$-ray emission is a little as 0.1 cph/cm$^2$ or less, so that when the resin compound is used as a sealing material for a semiconductor device, etc., occurrence of software error which is a malfunction of the semiconductor device, etc., by the $\alpha$-ray can be suppressed.

EMBODIMENTS OF THE INVENTION

Next, embodiments to carry out the present invention are explained. The black titanium oxynitride powder has a powder matrix of the black titanium oxynitride which becomes a core, and a silica film coating the powder matrix which becomes a shell. The powder matrix of the black titanium oxynitride is represented by the chemical formula: $TiN_XO_Y$ (wherein X=0.2 to 1.4, Y=0.1 to 1.8), or the chemical formula: $Ti_WO_{2W-1}$ (wherein W=1 to 10), and has a black color. Here, in the above-mentioned chemical formula: $TiN_XO_Y$, the reason why X is limited in the range of 0.2 to 1.4 is that if it is less than 0.2, blackness is insufficient since a reduction rate is low, while if it exceeds 1.4, it exhibits yellowish so that a predetermined color tone as a black pigment cannot be obtained. In addition, in the above-mentioned chemical formula: $TiN_XO_Y$, the reason why Y is limited in the range of 0.1 to 1.8 is that if it is outside the above range, a predetermined color tone as a black pigment cannot be obtained. Further, in the above-mentioned chemical formula: $Ti_WO_{2W-1}$, the reason why W is limited in the range of 1 to 10 is that a compound of less than 1 does not generally exist, while if it exceeds 10, a predetermined color tone as a black pigment cannot be obtained. Incidentally, a mass ratio of the oxygen and the nitrogen (O/N) of the above-mentioned chemical formula: $TiN_XO_Y$ is preferably in the range of 0.2 to 6.

On the other hand, the thickness of the above-mentioned silica film is 2.5 to 12 nm, and preferably in the range of 3.0 to 10.0 nm. Also, the black titanium oxynitride powder has a volume resistivity in a state of a pressurized powder body compacted with a pressure of 5 MPa of $1 \times 10^5$ $\Omega \cdot$cm or more, preferably $1.5 \times 10^6$ $\Omega \cdot$cm or more and $1.0 \times 10^{10}$ $\Omega \cdot$cm or less. The thickness of the above-mentioned silica film can be measured by an image photographed by a transmission electron microscope (TEM). Also, the above-mentioned volume resistivity can be measured, for example, by using a low resistivity meter Loresta-GP (Type: UV-3101PC) manufactured by Mitsubishi Chemical Corporation, by the four-terminal and four-probe method. This four-terminal and four-probe method is a method of obtaining a volume resistivity by placing four needle-shaped electrodes on the surface of a sample (a pressurized powder body) with predetermined intervals on the same line, passing a constant current between two needle-shaped electrodes at the outside, and measuring the potential difference generating between two needle-shaped electrodes at the inside. Here, the reason why the thickness of the silica film is limited in the range of 2.5 to 12 nm is that if it is less than 2.5 nm, the shielding property to the $\alpha$-ray emitted from impurities (in particular, lead) contained in the powder matrix of the black titanium oxynitride is not sufficient, while if it exceeds 12 nm, blackness of the black titanium oxynitride powder as a black pigment is insufficient. Also, the reason why the volume resistivity of the black titanium oxynitride powder in the state of a pressurized powder body is limited to $1 \times 10^5$ $\Omega \cdot cm$ or more is that if it is less than $1 \times 10^5$ $\Omega \cdot cm$, the powder matrix of the black titanium oxynitride is not completely coated by the silica film and a part of the powder matrix becomes in an exposed state, and as a result, electrical insulation of the semiconductor sealing material using the black titanium oxynitride powder as a filler is lowered. Incidentally, an average primary particle size of the powder matrix of the black titanium oxynitride which becomes a core is preferably in the range of 10 nm to 120 nm. The average primary particle size of the powder matrix is a particle diameter measured by using a transmission electron microscope (TEM), and is a volume-based average primary particle size. Here, the reason why the preferred range of the average primary particle size of the above-mentioned powder matrix is limited in the range of 10 nm to 120 nm is that if it is less than 10 nm, the particles are too fine and likely aggregated so that they cannot be dispersed uniformly in the resin compound for sealing a semiconductor, while if it exceeds 120 nm, the particles are too large and tinting strength (coloring power) is insufficient.

On the other hand, a lightness index L* value of the black titanium oxynitride powder in the CIE 1976 L*a*b* color space (measurement light source C: color temperature 6774K) is 14 or less, preferably 7 to 13. The above-mentioned CIE 1976 L*a*b* color space is a color space in which Commission Internationale de l'Eclairage (CIE) has changed the CIE XYZ color system in 1976, and determined that a certain distance in the color system has a substantially perceptually uniform difference in any of the color regions. Also, the lightness indexes L* value, a* value and b* value are amounts determined by the orthogonal coordinate system in the CIE 1976 L*a*b* color space, and represented by the following formula (1) to formula (3).

$$L^* = 116(Y/Y_0)^{1/3} - 16 \qquad \cdots\cdots (1)$$

$$a_* = 500[(X/X_0)^{1/3} - (Y/Y_0)^{1/3}] \quad \cdots\cdots (2)$$

$$b^* = 200[(Y/Y_0)^{1/3} - (Z/Z_0)^{1/3}] \quad \cdots\cdots (3)$$

Provided that $X/X_0$, $Y/Y_0$ and $Z/Z_0 > 0.008856$, and X, Y and Z are tristimulus values of object colors. Also, $X_0$, $Y_0$ and $Z_0$ are tristimulus values of a light source illuminating object colors, and are standardized to $Y_0 = 100$. Also, the lightness index L* value of the black titanium oxynitride powder is obtained by using, for example, a spectrophotometer (Type: SE2000) manufactured by NIPPON DENSHOKU INDUSTRIES, CO., LTD. Here, the reason why the lightness index L* value of the black titanium oxynitride powder is limited to 14 or less is that if it exceeds 14, blackness is insufficient and a predetermined color tone as the black pigment cannot be obtained.

A production method of the thus constituted black titanium oxynitride powder is explained. First, a white titanium oxide powder ($TiO_2$) is reduced by a reducing gas to obtain a powder matrix of the black titanium oxynitride. Here, when an ammonia gas is used as the reducing gas, a black titanium oxynitride represented by the chemical formula: $TiN_XO_Y$ (wherein X=0.2 to 1.4, Y=0.1 to 1.8) is generated. A reducing ratio of the above-mentioned white titanium oxide powder ($TiO_2$) can be controlled by heightening a reaction temperature, increasing the ammonia gas flow amount or elongating a reaction time, and when the reducing ratio is high, blackness of the powder is increased. That is, the L* value is low. The powder matrix of the black titanium oxynitride is wet-pulverized to obtain a dispersion of the powder matrix of the black titanium oxynitride. This wet-pulverization is carried out by pulverizing a powder matrix dispersed in an alcohol by a beads mill until the average primary particle size becomes in the range of 80 nm to 200 nm. Then, an alcohol for adjusting a concentration of a dispersion is added to the dispersion of the above-mentioned powder matrix, and a silica source for forming a silica film is added thereto. Here, as the alcohol, ethyl alcohol or propyl alcohol is preferably used, and as the silica source, one kind or two or more kinds of a compound(s) selected from the group consisting of tetraethyl orthosilicate (TEOS), tetramethyl orthosilicate, propyl silicate and butyl silicate is/are preferred. In particular, either one of tetraethyl orthosilicate (TEOS) or tetramethyl orthosilicate or both of them is/are further desirably used.

Next, an alkali source is added to the dispersion of the powder matrix of the black titanium oxynitride to which the silica source has been added, to start the reaction of the dispersion. Here, the alkali source is one kind or two or more kinds of an alkali catalyst(s) selected from the group consisting of NaOH, KOH, $Na_2CO_3$, $K_2CO_3$, $NaHCO_3$, $KHCO_3$, $NH_4OH$, $(NH_4)_2CO_3$ and $NH_4HCO_3$. Further, the above-mentioned dispersion is washed and dried, and then, sintered.

Washing of the above-mentioned dispersion is carried out to remove impurities from the dispersion by applying the dispersion to a centrifugal separator or passing the dispersion through a filter made of an ion exchange resin. Also, the above-mentioned sintering is a treatment in which the material is maintained in an inert gas atmosphere at 100 to 400°C for 1 to 10 hours, and a black titanium oxynitride powder which is a powder matrix of the black titanium oxynitride coated by a silica film can be obtained by the sintering. Here, the reason why the sintering temperature is limited within the range of 100 to 400°C is that, if it is lower than 100°C, the polycondensation reaction does not proceed and formation of the silica film is insufficient, while if it exceeds 400°C, the silica film is cracked by grain growth of the powder matrix of the black titanium oxynitride. In addition, the reason why the sintering time is limited within the range of 1 to 10 hours is that if it is shorter than 1 hour, formation of the silica film is insufficient, while if it exceeds 10 hours, the silica film is cracked by grain growth of the powder matrix of the black titanium oxynitride. In the thus produced black titanium oxynitride powder, the silica film is formed by the sol-gel reaction generated at the surface of the powder matrix of the black titanium oxynitride, i.e., formed by the reaction such as hydrolysis and polycondensation, etc., so that the silica film becomes dense and no crack is generated to the silica film. As a result, good electrical insulation of the black titanium oxynitride powder can be maintained.

Next, a method of producing a resin compound for sealing a semiconductor by using the thus produced black titanium oxynitride powder is explained. First, an epoxy resin, a curing agent, a curing accelerator and an inorganic filler are mixed to prepare a mixture. The epoxy resin is preferably a polyfunctional type epoxy resin, and specific examples thereof may be mentioned a biphenyl type epoxy resin, a glycidylamine type epoxy resin, a triphenylglycidylmethane type epoxy resin, a tetraphenylglycidylmethane type epoxy resin, an aminophenol type epoxy resin, a diaminodiphenylmethane type epoxy resin, a phenol novolak type epoxy resin, an ortho-cresol type epoxy resin, a bisphenol A novolak resin, etc. The curing agent may be mentioned a primary amine, a secondary amine, a phenol resin (for example, a phenol novolac resin), an acid anhydride, etc. The curing accelerator may be mentioned, for example, an imidazole compound such as 2-methylimidazole, 2-phenylimidazole, 2-phenyl-4-methylimidazole, etc., and a tertiary amine, for example, triethanolamine, dimethylaminoethanol, tris(dimethylaminomethyl)phenol, etc. The inorganic filler may be mentioned crystalline silica, amorphous silica, alumina, silicon nitride, aluminum nitride, etc. In addition, based on 100% by mass of the above-mentioned mixture, a contained ratio of the epoxy resin is preferably 3 to 40% by mass, a contained ratio of the curing agent is preferably 1 to 30% by mass, a contained ratio of the curing accelerator is preferably 0.1 to 3.0% by mass and a contained ratio of the inorganic filler is preferably 60 to 95% by mass. Next, the black titanium oxynitride powder is added to the mixture as a filler to disperse black titanium oxynitride powder into the mixture. A contained ratio of the above-mentioned black titanium oxynitride powder is preferably in the range of 0.05 to 10% by mass based on 100% by mass of the total amount of the above-mentioned mixture and the black titanium oxynitride powder, more preferably in the range of 0.1 to 5.0% by mass. The resin compound for sealing a semiconductor is thus produced. The amount of an $\alpha$-ray emission of the resin compound for sealing a semiconductor is preferably 0.1 cph/cm$^2$ or less, more preferably 0.05 cph/cm$^2$ or less.

Here, the reason why the contained ratio of the epoxy resin based on 100% by mass of the mixture is limited in the range of 3 to 40% by mass is that if it is less than 3% by mass, adhesiveness to the semiconductor device or the substrate, etc., is insufficient, while if it exceeds 40% by mass, strength as the sealing material is insufficient. Also, the reason why the contained ratio of the curing agent based on 100% by mass of the mixture is limited in the range of 1 to 30% by mass is that if it is less than 1% by mass, curing of the resin compound is insufficient so that strength of the sealing material is insufficient, while if it exceeds 30% by mass, preservation stability of the resin compound before curing is insufficient. Further, the reason why the contained ratio of the curing accelerator based on 100% by mass of the mixture is limited in the range of 0.1 to 3.0% by mass is that if it is less than 0.1% by mass, curing of the resin compound is insufficient so that strength of the sealing material is insufficient, while if it exceeds 3.0% by mass, preservation stability of the resin compound before curing is insufficient. Moreover, the reason why the contained ratio of the inorganic filler based on 100% by mass of the mixture is limited in the range of 60 to 95% by mass is that if it is less than 60% by mass, strength as the sealing material is insufficient, while if it exceeds 95% by mass, adhesiveness to the semiconductor device or the substrate, etc., is insufficient. Furthermore, the reason why the contained ratio of the black titanium oxynitride powder based on 100% by mass of the total amount of the mixture of the black titanium oxynitride powder is limited in the range of 0.05 to 10% by mass is that if it is less than 0.05% by mass, blackness of the sealing material is lowered, while if it exceeds 10% by mass, adhesiveness to the semiconductor device or the substrate, etc., is insufficient. Further, the reason why the amount of the $\alpha$-ray emission of the resin compound for sealing a semiconductor is limited to 0.1 cph/cm$^2$ or less is that if it exceeds 0.1 cph/cm$^2$, there is a fear of generating a software error when a semiconductor is sealed by using the resin compound for sealing a semiconductor.

Into the resin compound for sealing a semiconductor containing these respective components may be optionally formulated an additive, depending on necessity, including a silicone-based flexibilizer for lowering elastic modulus, heightening toughness or heightening humidity resistance, etc., of the sealing material, a releasing agent for easily releasing a molded product from a mold, a coupling agent for improving a wetting property or adhesiveness of the resin component and the filler, a flame retardant and a flame retardant auxiliary for providing flame retardancy, etc.

When a semiconductor device is sealed by using the thus produced resin compound for sealing a semiconductor, the black titanium oxynitride powder contained in the sealing material has high electrical insulation and a high shielding property to an $\alpha$-ray, so that even when a wiring pitch of the semiconductor device becomes narrow, the black titanium oxynitride powder in the sealing material does not short-circuit the wirings, and generation of the software error which is a malfunction of the semiconductor device by the $\alpha$-ray can be suppressed.

EXAMPLES

Next, Examples of the present invention are explained in detail with Comparative examples.

<Example 1>

First, white titanium oxide powder ($TiO_2$) was reduced by an ammonia gas (reducing gas) to obtain a powder matrix of black titanium oxynitride. Here, a reducing reaction time (a contacting time of the white titanium oxide powder with an ammonia gas) was made 120 minutes. The powder matrix of the black titanium oxynitride is represented by the chemical formula: $TiN_XO_Y$ (wherein X=0.3 and Y=0.9). To 0.1 mol of the powder matrix was added 12 mol of ethanol as an alcohol to disperse the powder matrix in ethanol, and the mixture was wet pulverized by a beads mill to obtain a dispersion of the powder matrix having an average primary particle size of 150 nm. Then, to the dispersion of the powder matrix was added 6 mol of ethanol for adjusting the concentration, thereafter $1 \times 10^{-2}$ mol of tetramethyl orthosilicate was added as a silica source for forming a silica film. Next, to the dispersion of the powder matrix to which the tetramethyl orthosilicate has been added was added $1 \times 10^{-3}$ mol of sodium hydroxide as an alkali source (a reaction initiator) to start the reaction in the dispersion. Further, the dispersion was washed and dried, and then, sintered to obtain a black titanium oxynitride powder having a volume resistivity of $7.50 \times 10^5$ $\Omega \cdot$cm in which the powder matrix of the black titanium oxynitride has been coated by a silica film with a thickness of 2.56 nm. Provided that washing of the above-mentioned dispersion was carried out by applying the dispersion to a centrifugal separator to remove impurities from the dispersion, and then, passing the dispersion through a filter made of an ion exchange resin. In addition, the above-mentioned sintering was a treatment to maintain the material in a nitrogen atmosphere at 350°C for 5 hours. This black titanium oxynitride powder is made Example 1. Incidentally, a thickness of the silica film was measured from an image photographed by a transmission electron microscope (TEM). Also, the volume resistivity of the black titanium oxynitride powder was measured by the four-terminal and four-probe method in the state of a pressurized powder body in which the black titanium oxynitride powder has been compacted with a pressure of 5 MPa, by using a low resistivity meter Loresta-GP (Type: UV3101PC) manufactured by Mitsubishi Chemical Corporation.

<Example 2>

In the same manner as in Example 1 except that tetramethyl orthosilicate was added in an amount of $2 \times 10^{-2}$ mol and sodium hydroxide was added as an alkali source (a reaction initiator) in an amount of $1 \times 10^{-3}$ mol, to obtain a black titanium oxynitride powder having a volume resistivity of $9.00 \times 10^6$ $\Omega \cdot$cm in which the powder matrix of the black titanium oxynitride has been coated by a silica film with a thickness of 3.50 nm. This black titanium oxynitride powder is made Example 2.

<Example 3>

In the same manner as in Example 1 except that tetramethyl orthosilicate was added in an amount of $3 \times 10^{-2}$ mol and potassium hydroxide was added as an alkali source (a reaction initiator) in an amount of $1 \times 10^{-3}$ mol, to obtain a black titanium oxynitride powder having a volume resistivity of $1.00 \times 10^7$ $\Omega \cdot$cm or more in which the powder matrix of the black titanium oxynitride has been coated by a silica film with a thickness of 5.90 nm. This black titanium oxynitride powder is made Example 3.

<Example 4>

In the same manner as in Example 1 except that tetramethyl orthosilicate was added in an amount of $4 \times 10^{-2}$ mol and potassium hydroxide was added as an alkali source (a reaction initiator) in an amount of $1 \times 10^{-3}$ mol, to obtain a black titanium oxynitride powder having a volume resistivity of $1.00 \times 10^7$ $\Omega \cdot$cm or more in which the powder matrix of the black titanium oxynitride has been coated by a silica film with a thickness of 7.20 nm. This black titanium oxynitride powder is made Example 4.

<Example 5>

In the same manner as in Example 1 except that tetramethyl orthosilicate was added in an amount of $5\times10^{-2}$ mol and aqueous ammonia was added as an alkali source (a reaction initiator) in an amount of $8\times10^{-3}$ mol, to obtain a black titanium oxynitride powder having a volume resistivity of $1.00\times10^{7}$ $\Omega\cdot$cm or more in which the powder matrix of the black titanium oxynitride has been coated by a silica film with a thickness of 10.25 nm. This black titanium oxynitride powder is made Example 5.

<Example 6>

In the same manner as in Example 1 except that tetramethyl orthosilicate was added in an amount of $10\times10^{-2}$ mol and aqueous ammonia was added as an alkali source (a reaction initiator) in an amount of $5\times10^{-3}$ mol, to obtain a black titanium oxynitride powder having a volume resistivity of $1\times10^{7}$ $\Omega\cdot$cm in which the powder matrix of the black titanium oxynitride has been coated by a silica film with a thickness of 12.00 nm. This black titanium oxynitride powder is made Example 6.

<Example 7>

In the same manner as in Example 1 except that tetraethyl orthosilicate was added in an amount of $1.0\times10^{-2}$ mol and aqueous ammonia was added as an alkali source (a reaction initiator) in an amount of $5\times10^{-3}$ mol, to obtain a black titanium oxynitride powder having a volume resistivity of $1.00\times10^{5}$ $\Omega\cdot$cm in which the powder matrix of the black titanium oxynitride has been coated by a silica film with a thickness of 2.50 nm. This black titanium oxynitride powder is made Example 7.

<Comparative example 1>

In the same manner as in Example 1 except that no tetramethyl orthosilicate was added, i.e., no silica film was formed onto the surface of the powder matrix, to obtain a black titanium oxynitride powder having a volume resistivity of $5.50\times10^{0}$ $\Omega\cdot$cm. This black titanium oxynitride powder is made Comparative example 1.

<Comparative example 2>

In the same manner as in Example 1 except that tetramethyl orthosilicate was added in an amount of $0.5\times10^{-2}$ mol and sodium hydroxide was added as an alkali source (a reaction initiator) in an amount of $1\times10^{-3}$ mol, to obtain a black titanium oxynitride powder having a volume resistivity of $0.80\times10^{5}$ $\Omega\cdot$cm in which the powder matrix of the black titanium oxynitride has been coated by a silica film. This black titanium oxynitride powder is made Comparative example 2. Incidentally, a thickness of the silica film of Comparative example 2 could not be measured by an electron microscopic photograph, so that it was unknown.

<Comparative example 3>

In the same manner as in Example 1 except that tetramethyl orthosilicate was added in an amount of $0.8\times10^{-2}$ mol, to obtain a black titanium oxynitride powder having a volume resistivity of $1.00\times10^{5}$ $\Omega\cdot$cm in which the powder matrix of the black titanium oxynitride has been coated by a silica film with a thickness of 2.30 nm. This black titanium oxynitride powder is made Comparative example 3.

<Comparative example 4>

In the same manner as in Example 1 except that tetramethyl orthosilicate was added in an amount of $12\times10^{-2}$ mol and potassium hydroxide was added as an alkali source (a reaction initiator) in an amount of $1\times10^{-3}$ mol, to obtain a black titanium oxynitride powder having a volume resistivity of $0.90\times10^{6}$ $\Omega\cdot$cm in which the powder matrix of the black titanium oxynitride has been coated by a silica film with a thickness of 13.00 nm. This black titanium oxynitride powder is made Comparative example 4.

<Comparative example 5>

In the same manner as in Example 1 except that tetramethyl orthosilicate was added in an amount of $15\times10^{-2}$ mol and aqueous ammonia was added as an alkali source (a reaction initiator) in an amount of $5\times10^{-3}$ mol, to obtain a black titanium oxynitride powder having a volume resistivity of $1.00\times10^7$ $\Omega\cdot$cm or more in which the powder matrix of the black titanium oxynitride has been coated by a silica film with a thickness of 14.00 nm. This black titanium oxynitride powder is made Comparative example 5.

<Comparative example 6>

In the same manner as in Example 1 except that tetramethyl orthosilicate was added in an amount of $20\times10^{-2}$ mol and aqueous ammonia was added as an alkali source (a reaction initiator) in an amount of $5\times10^{-3}$ mol, to obtain a black titanium oxynitride powder having a volume resistivity of $1.00\times10^7$ $\Omega\cdot$cm or more in which the powder matrix of the black titanium oxynitride has been coated by a silica film with a thickness of 16.00 nm. This black titanium oxynitride powder is made Comparative example 6.

<Comparative example 7>

In the same manner as in Example 1 except that a reaction time for producing the powder matrix of the black titanium oxynitride by reducing the white titanium oxide powder ($TiO_2$) with an ammonia gas in Example 1 was made a half of that of Example 1 to produce a powder matrix of the black titanium oxynitride which is low in the reducing ratio of the white titanium oxide powder ($TiO_2$), to obtain a black titanium oxynitride powder having a volume resistivity of $4.50\times10^6$ $\Omega\cdot$cm in which the powder matrix of the black titanium oxynitride has been coated by a silica film with a thickness of 3.60 nm. This black titanium oxynitride powder is made Comparative example 7.

<Comparative test 1 and evaluation>

With regard to the black titanium oxynitride powder of Examples 1 to 7 and Comparative examples 1 to 7, an L* value was measured. A lightness index L* value of the black titanium oxynitride powder was obtained by using a spectrophotometer (Type: SE2000) manufactured by NIPPON DENSHOKU INDUSTRIES, CO., LTD.
On the other hand, resin compounds for sealing a semiconductor were produced by using the black titanium oxynitride powders of Examples 1 to 7 and Comparative examples 1 to 7, respectively, and semiconductors were sealed by using these resin compounds, respectively. Specifically, 6% by mass of a biphenyl type epoxy resin (epoxy resin), 3% by mass of a phenol novolac resin curing agent (curing agent), 0.2% by mass of 2-methylimidazole (curing accelerator) and 90.8% by mass of amorphous silica (inorganic filler) were firstly mixed to prepare a mixture. Next, by adding 2% by mass of the black titanium oxynitride powder based on 100% by mass of the total amount of the mixture and the above-mentioned black titanium oxynitride powder to produce the resin compounds for sealing a semiconductor, respectively. Further, by using these resin compounds for sealing a semiconductor, semiconductors were sealed, respectively. These sealing materials were made sealing materials of Examples 1 to 7 and Comparative examples 1 to 7, and electrical insulation, blackness and the amount of the $\alpha$-ray emission of these sealing materials were each measured. Electrical insulation of the above-mentioned sealing materials was measured by a resin encapsulation type semiconductor apparatus. And the example in which no leak current was observed is judged to be good, while the example in which the leak current was observed is judged to be bad. Further, the blackness of the above-mentioned sealing material was measured by a spectrophotometer. And the L* value of 30 or less is judged to be good, while the L* value exceeded 30 is judged to be insufficient. Here, the reason why the standard value (an upper limit value in the range of good) of the L* value of the black titanium oxynitride powder is 14, but the standard value (an upper limit value in the range of good) of the L* value of the sealing material is large as 30 is that the contained ratio of the black titanium oxynitride powder in the sealing material is low as 2% by mass. Moreover, the amount of the $\alpha$-ray emission of the above-mentioned sealing material was measured by using an $\alpha$-ray measurement device (Model number: SSB, manufactured by EG&G ORTEC Co.). These results are shown in Table 1 with the thickness of the silica film and the volume resistivity of the black titanium oxynitride powder. Incidentally, in Table 1, failure in formation of electrical insulation of Comparative example 6 means that the black titanium oxynitride powder of Comparative example 6 was dispersed in ethanol, the dispersion was gelated whereby the sealing material could not be produced and electrical insulation could not be measured. Therefore, in Comparative example 6, blackness and the amount of the $\alpha$-ray emission of the sealing material could not even be measured.

[Table 1]

| | | Black titanium oxynitride powder | | | Sealing material | | |
|---|---|---|---|---|---|---|---|
| | | Thickness of silica film (nm) | Volume resistivity ($\Omega \cdot cm$) | L* value | Electrical insulation | Blackness | $\alpha$-ray emission amount (cph/cm$^2$) |
| | Example 1 | 2.56 | $7.50 \times 10^5$ | 10.5 | Good | Good | 0.1 or less |
| | Example 2 | 3.50 | $9.00 \times 10^6$ | 10.7 | Good | Good | 0.1 or less |
| | Example 3 | 5.90 | $1.00 \times 10^7$ or more | 11.2 | Good | Good | 0.1 or less |
| | Example 4 | 7.20 | $1.00 \times 10^7$ or more | 12.8 | Good | Good | 0.1 or less |
| | Example 5 | 10.25 | $1.00 \times 10^7$ or more | 13.5 | Good | Good | 0.1 or less |
| | Example 6 | 12.00 | $1.00 \times 10^7$ or more | 13.9 | Good | Good | 0.1 or less |
| | Example 7 | 2.50 | $1.00 \times 10^5$ | 10.4 | Good | Good | 0.1 or less |
| | Comparative example 1 | 0 | $5.50 \times 10^0$ | 10.4 | Poor | Good | 0.5 |
| | Comparative example 2 | Unknown | $0.80 \times 10^5$ | 10.5 | Poor | Good | 1.0 |
| | Comparative example 3 | 2.30 | $1.00 \times 10^5$ | 10.1 | Poor | Good | 0.2 |
| | Comparative example 4 | 13.00 | $0.90 \times 10^6$ | 14.1 | Good | Insufficient | 0.1 or less |
| | Comparative example 5 | 14.00 | $1.00 \times 10^7$ or more | 14.3 | Good | Insufficient | 0.1 or less |
| | Comparative example 6 | 16.00 | $1.00 \times 10^7$ or more | 15.5 | Failure in formation Gelated | - | - |
| | Comparative example 7 | 3.60 | $4.50 \times 10^6$ | 22.5 | Good | Insufficient | 0.1 or less |

As can be clearly seen from Table 1, in Comparative example 1 in which no silica film was formed onto the surface of the powder matrix of the black titanium oxynitride powder and a volume resistivity in the state of a pressurized powder body was small as $5.50 \times 10^0$ $\Omega \cdot cm$, in the sealing material using the black titanium oxynitride powder, blackness was good but electrical insulation was poor and an emitted amount of the $\alpha$-ray was large as 0.5 cph/cm$^2$. Also, in Comparative example 3 in which a volume resistivity of the black titanium oxynitride powder in the state of a pressurized powder body was suitable as $1.00 \times 10^5$ $\Omega \cdot cm$, but a thickness of the silica film was thin as 2.3 nm, in the sealing material using the black titanium oxynitride powder, blackness was good but electrical insulation was poor and an emitted amount of the $\alpha$-ray was much as 0.2 cph/cm$^2$. Further, in Comparative examples 4 and 5 in which volume resistivities of the black titanium oxynitride powder in the state of a pressurized powder body were suitable as $0.90 \times 10^6$ $\Omega \cdot cm$ and $1.00 \times 10^7$ $\Omega \cdot cm$ or more, respectively, but thicknesses of the silica film were thick as 13.00 nm and 14.00 nm, respectively, in the sealing materials using the black titanium oxynitride powders, electrical insulation was both good and an emitted amount of the $\alpha$-ray was both little as 0.1 cph/cm$^2$ or less, but blackness was both insufficient. To the contrary, in Examples 1 to 7 in which thicknesses of the silica films of the black titanium oxynitride powders were suitable as 2.5 nm to 12.00 nm and volume resistivities in the state of a pressurized powder body were suitable as $1.00 \times 10^5$ $\Omega \cdot cm$ or more, in the sealing materials using the black titanium oxynitride powders, electrical insulation and blackness were both good and emitted amounts of the $\alpha$-ray were all little as 0.1 cph/cm$^2$ or less.

On the other hand, in Comparative example 7 in which a thickness of the silica film of the black titanium oxynitride powder was suitable as 3.60 nm and volume resistivity in the state of a pressurized powder body was suitable as

$4.50 \times 10^6$ Ω·cm, but the reaction time for producing the powder matrix of the black titanium oxynitride by reducing the white titanium oxide powder with an ammonia gas was made a half to that of Example 1 so that the reducing ratio of the black titanium oxynitride powder was insufficient, in the sealing material using the black titanium oxynitride powder, electrical insulation was good and an emitted amount of the α-ray was also little as 0.1 cph/cm$^2$ or less, but blackness was insufficient. Also, in Comparative example 2 in which a thickness of the silica film could not be measured by an electron microscopic photograph and volume resistivity in the state of a pressurized powder body was small as $0.80 \times 10^5$ Ω·cm, in the sealing material using the black titanium oxynitride powder, blackness was good but electrical insulation was poor and an emitted amount of the α-ray was also large as 1.0 cph/cm$^2$. Incidentally, in Comparative example 2, the reason why the thickness of the silica film could not be measured by the electron microscopic photograph is that the silica film did not exhibit a shape of a continuous film.

INDUSTRIAL APPLICABILITY

The black titanium oxynitride powder of the present invention can be utilized as a filler which is dispersed in a resin compound of a sealing material for sealing a semiconductor device, such as a filler for coloring the sealing material black color for shielding an inside thereof or a filler for subjecting to laser mark for printing of the sealing material such as a lot number, etc., or as a filler which is dispersed in sealing material for sealing a power semiconductor device for on-vehicle for flowing a large current, such as a filler of a sealing material required to have high electrical insulation. In addition, since the black titanium oxynitride powder of the present invention has high electrical insulation, it can be utilized as a coloring material for an electron display element, for example, a resin black matrix of a liquid crystal color filter, a black film requiring blackness and electrical insulation in a black sealing material, a rib material, a flexible printed substrate, etc.

**Claims**

1.  A black titanium oxynitride powder which comprises a powder matrix of the black titanium oxynitride, and a silica film having a thickness of 2.5 to 12 nm when measured by a transmission electron microscope (TEM) and coating onto a surface of the powder matrix, a volume resistivity in a state of a pressurized powder body compacted with a pressure of 5 MPa of which is $1 \times 10^5$ Ω·cm or more when measured by a four-terminal and four-probe method, a lightness index L* value in the CIE 1976 L*a*b* color space (measurement light source C: color temperature 6774K) of the powder is 14 or less, and it is used for a resin compound for sealing a semiconductor.

2.  A resin compound for sealing a semiconductor which comprises the black titanium oxynitride powder according to claim 1 being dispersed in a mixture of an epoxy resin, a curing agent, a curing accelerator and an inorganic filler.

3.  The resin compound for sealing a semiconductor according to claim 2, wherein a contained ratio of the black titanium oxynitride powder is 0.05 to 10% by mass based on 100% by mass of the total amount of the mixture of the epoxy resin, the curing agent, the curing accelerator and the inorganic filler, and the black titanium oxynitride powder.

4.  The resin compound for sealing a semiconductor according to claim 3, wherein the amount of an α-ray emission is 0.1 cph/cm$^2$ or less.

**Patentansprüche**

1.  Ein schwarzes Titanoxynitridpulver, das eine Pulvermatrix des schwarzen Titanoxynitrids und einen Siliciumdioxidfilm mit einer Dicke von 2,5 bis 12 nm, gemessen mittels Transmissionselektronenmikroskopie (TEM) und beschichtet auf einer Oberfläche der Pulvermatrix, umfasst, mit einem Volumenwiderstand in einem Zustand eines druckbelasteten Pulverkörpers komprimiert mit einem Druck von 5 MPa $1 \times 10^5$ Ω · cm oder mehr, gemessen mittels Vierleitermessung oder Viersondenmessung, einem Wert des Helligkeitsindex L* im Farbbereich CIE 1976 L*a*b* (Messlichtquelle C: Farbtemperatur 6774K) des Pulvers von 14 oder weniger, welches für eine Harzverbindung zum Abdichten eines Halbleiters verwendet wird.

2.  Harzverbindung zum Abdichten eines Halbleiters, umfassend das schwarze Titanoxynitridpulver gemäß Anspruch 1, das in einer Mischung aus einem Epoxidharz, einem Härtungsmittel, einem Härtungsbeschleuniger und einem anorganischen Füllstoff dispergiert ist.

**3.** Harzverbindung zum Abdichten eines Halbleiters gemäß Anspruch 2, worin ein enthaltenes Verhältnis des schwarzen Titanoxynitridpulvers 0,05 bis 10 Massen-%, bezogen auf 100 Massen-% der Gesamtmenge der Mischung des Epoxidharzes, des Härtungsmittels, des Härtungsbeschleunigers und des anorganischen Füllstoffs und des schwarzen Titanoxynitridpulvers beträgt.

**4.** Harzverbindung zum Abdichten eines Halbleiters gemäß Anspruch 3, worin die Menge einer $\alpha$-Strahlenemission 0,1 cph / cm$^2$ oder weniger beträgt.

**Revendications**

**1.** Poudre noire d'oxynitrure de titane, qui comprend une matrice de poudre de l'oxynitrure de titane noire, et un film de silice ayant une épaisseur comprise entre 2,5 et 12 nm si elle est mesurée par un microscope électronique en transmission (MET) et si le film est appliqué sur une surface de la matrice de poudre, une résistance volumique dans un état d'un corps de poudre pressurisé compacté avec une pression de 5 MPa dont est $1\times10^5\ \Omega \cdot cm$ ou plus si elle est mesurée à l'aide d'un procédé à quatre terminaux et à quatre sondes, une valeur d'indice de luminosité L* dans l'espace de couleur L*a*b* de la CIE 1976 (source de lumière de mesure C : température de couleur 6774K) du poudre étant 14 ou moins, et il est utilisé pour un composé de résine destiné à sceller un semi-conducteur.

**2.** Composé de résine pour sceller un semi-conducteur, qui comprend la poudre d'oxynitrure de titane noire selon la revendication 1, qui est dispersée dans un mélange d'une résine époxy, d'un agent durcisseur, d'un accélérateur de durcissement et d'une charge inorganique.

**3.** Composé de résine pour sceller un semi-conducteur selon la revendication 2, dans lequel un rapport contenu de la poudre d'oxynitrure de titane noire est 0,05 à 10 % en masse basé sur 100 % en masse de la quantité totale du mélange de la résine époxy, de l'agent durcisseur, de l'accélérateur de durcissement et de la charge inorganique, et de la poudre d'oxynitrure de titane noire.

**4.** Composé de résine pour sceller un semi-conducteur selon la revendication 3, dans lequel la quantité d'une émission de rayons $\alpha$ est 0,1 cph/cm$^2$ ou moins.

**EP 3 085 736 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005206621 A
- US 2008017835 A1
- US 2008318018 A1
- JP 2006182627 A
- JP 2002267832 A